# EUROPÄISCHE PATENTANMELDUNG

(11) **EP 1 495 815 A1**
(43) Veröffentlichungstag der Anmeldung: **12.01.2005**
(21) Anmeldenummer: 04015751.3
(22) Anmeldetag: 05.07.2004
(51) Int. Cl.: B21B 45/02, C23C 2/28, C23C 2/26, B21D 28/16, H05K 3/00

(54) **Verfahren zum Reinigen einer metallischen Oberfläche**

(30) Priorität: 09.07.2003 DE 10331132
(71) Anmelder: Stahl Biebertal GmbH, 35444 Biebertal (DE)
(72) Erfinder: Dönges, Marco, 35444 Biebertal (DE); Mandler, Hans-Peter, 35444 Biebertal (DE)
(74) Vertreter: Haar, Lucas H., Dipl.-Ing.

(57) **Zusammenfassung**

Beschrieben ist ein Verfahren zur Eliminierung von an der Oberfläche eines Bauteils (1) lose haftenden oder hochstehenden Partikeln, die aus dem die Oberfläche des Bauteils (1) bildenden Metall, insbesondere Zinn oder einer Zinnlegierung, bestehen, bei welchem die Oberfläche des Bauteils (1) in einer Schutzgasatmosphäre (4) auf eine Prozeßtemperatur erwärmt wird, die gleich der Schmelztemperatur des die Oberfläche bildenden Metalls oder geringfügig niedriger als diese ist.

## Beschreibung

Die Erfindung betrifft ein Verfahren zur Eliminierung von an der Oberfläche eines Bauteils lose haftenden Partikeln, die aus dem die Oberfläche des Bauteils bildenden Metall, insbesondere Zinn oder einer Zinnlegierung bestehen.

In elektrischen oder elektronischen Anlagen und Geräten werden Bauteile verwendet, die mit einer Oberflächenschicht aus Zinn oder einer Zinnlegierung versehen sind. Die Bauteile werden in der Regel aus elektrolytisch verzinntem Stahlblech durch verschiedene Umformprozesse hergestellt. Bei der Umformung entstehen an der Oberfläche der Bauteile feine Partikel in Form von Spänen und Abrieb, sogenannte Flitter, die im wesentlichen aus dem Oberflächenmaterial, nämlich Zinn bestehen. Die Größe der lose anhaftenden oder nur teilweise gelösten, hochstehenden Partikel hängt in starkem Maße vom Abnutzungsgrad bzw. von der Ausführung der verwendeten Stanz- und Biegewerkzeuge ab. Durch die auf der Oberfläche der Bauteile haftenden Partikel kann es bei den Prozessen zur weiteren Verarbeitung der Bauteile zu Kurzschlüssen und dadurch bedingten Schäden kommen, und die Funktionalität der Endprodukte kann beeinträchtigt oder gestört werden. Es besteht daher das Bestreben, die Bauteile nach Beendigung der Umformung möglichst gründlich von lose an der Oberfläche haftenden Partikeln zu reinigen.

Ein bisher angewendetes Verfahren besteht darin, mit Hilfe von Pinseln und Bürsten die an der Oberfläche derartiger Bauteile anhaftenden Partikel zu entfernen. Dieses Verfahren ist jedoch aufwendig und nicht sehr zuverlässig.

Es ist weiterhin bekannt, vergleichbare Bauteile nach der Umformung mittels einer sogenannten "Spritzwasser-Entfettung" zu reinigen. Auch dieses Verfahren führt jedoch nicht zu einem zufriedenstellenden Ergebnis.

Der Erfindung liegt die Aufgabe zugrunde, ein Verfahren der eingangs genannten Art anzugeben, welches eine zuverlässige und vollständige Beseitigung der lose an der Oberfläche haftenden Partikel ermöglicht.

Zur Lösung dieser Aufgabe ist erfindungsgemäß vorgesehen, daß zumindest die Oberfläche des zu reinigenden Bauteils in einer Schutzgasatmosphäre kurzzeitig auf eine Temperatur erwärmt wird, die gleich der Schmelztemperatur des die Oberfläche bildenden Metalls oder geringfügig niedriger als diese Schmelztemperatur ist.

Die Erfindung macht sich die Erkenntnis zunutze, daß bereits bei einer kurzzeitigen Erwärmung der Oberfläche verzinnter Bauteile auf eine Temperatur nahe der Schmelztemperatur des Oberflächenmetalls, die aus dem gleichen Metall bestehenden und nur lose an der Oberfläche haftenden Partikel sich wieder so fest mit der Oberfläche verbinden, daß bei der weiteren Verarbeitung der Bauteile oder im fertiggestellten Endprodukt keine Schäden oder Störungen durch sich lösende und herabfallende Partikel auftreten können.

Es hat sich bei dem erfindungsgemäßen Verfahren weiterhin als zweckmäßig erwiesen, wenn die Bauteile nach der Erwärmung ihrer Oberfläche unter Schutzgas auf eine Temperatur abgekühlt werden, bei der keine Oxydation des Oberflächenmaterials der Bauteile stattfinden kann. Bei einem Bauteil mit verzinnter Oberfläche hat sich eine Abkühlung unter Schutzgas auf eine Temperatur von maximal 100° C als geeignet erwiesen. Die weitere Abkühlung der Bauteile kann dann unter Luft erfolgen. Vielfach ist es erwünscht, die Bauteile noch mit einem Korrosionsschutzmittel zu behandeln. Nach einem weiteren Vorschlag der Erfindung ist es vorteilhaft, wenn die Bauteile hierzu auf eine Temperatur von maximal 80° C abgekühlt werden.

Eine weitere vorteilhafte Ausgestaltung des erfindungsgemäßen Verfahrens sieht vor, daß das Erwärmen der Bauteile auf Schmelztemperatur gleichzeitig dazu verwendet wird, um zwei Fügestellen durch Weichlöten zu fügen.

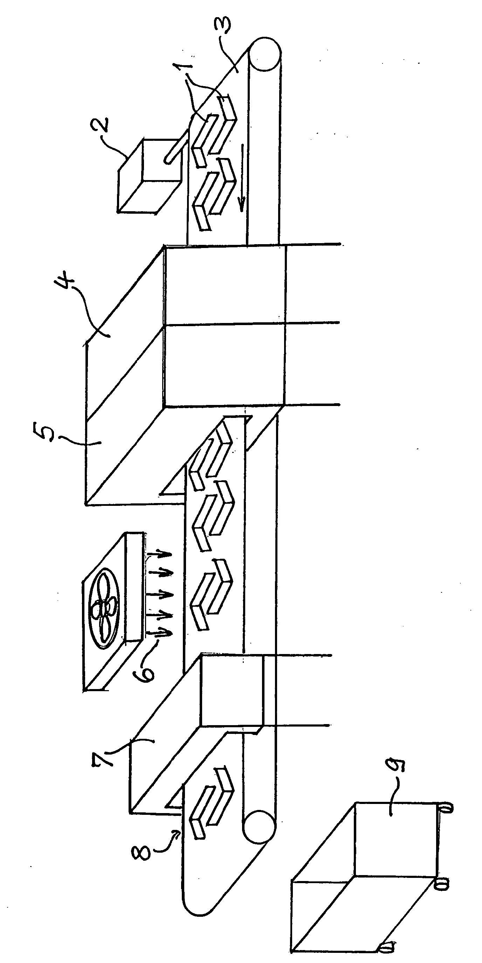

Ein Anwendungsbeispiel des erfindungsgemäßen Verfahrens wird nachfolgend anhand der Zeichnung näher beschrieben.

Aus verzinntem Blech ausgestanzte und gebogene Bauteile 1 werden von Hand auf ein durch einen Motor 2 angetriebenes Förderband 3 aufgelegt. Auf dem Förderband 3 gelangen die Bauteile 1 zunächst in eine Ofen 4, in dem sie unter Schutzgas auf Prozeßtemperatur von ca. 260° C erwärmt werden. Die Verweildauer der Teile im Ofen 4 kann je nach der Größe der Teile wenige Sekunden bis zu 1 oder 2 Minuten betragen. Aus dem Ofen 4 gelangen die Bauteile 1 in eine Kühlkammer 5, in der sie unter Schutzgas auf eine Temperatur von maximal 100° C abgekühlt werden. Die aus der Kühlkammer 5 austretenden Bauteile 1 werden anschließend mit einem Luftstrom 6 auf maximal 80° C abgekühlt, bevor sie erneut in eine Kammer 7 transportiert werden, in der mittels Sprühvernebelung ein Korrosionsschutzmittel aufgebracht wird. An die Kammer 7 schließt sich eine Trocknungsstrecke 8 an, auf der die Bauteile 1 an der Umgebungsluft getrocknet werden. Die getrockneten Teile werden dann von Hand in einen Versandbehälter 9 verpackt.

Die Erfindung ist nicht auf das beschriebene Anwendungsbeispiel beschränkt. Das erfindungsgemäße Verfahren kann auch bei verzinkten Teilen eingesetzt werden. Auch bei Oberflächen aus anderen Metallen, deren Schmelztemperatur in einem geeigneten Bereich liegt, ist eine Anwendung des erfindungsgemäßen Verfahrens denkbar.

## Patentansprüche

1. Verfahren zur Eliminierung von an der Oberfläche eines Bauteils lose haftenden oder hochstehenden Partikeln, die aus dem die Oberfläche des Bauteils bildenden Metall, insbesondere Zinn oder einer Zinnlegierung bestehen, **dadurch gekennzeichnet, daß** die Oberfläche des Bauteils in einer Schutzgasatmosphäre auf eine Prozeßtemperatur erwärmt wird, die gleich der Schmelztemperatur des die Oberfläche bildenden Metalls oder geringfügig niedriger als diese Schmelztemperatur ist.

2. Verfahren nach Anspruch 1, **dadurch gekennzeichnet, daß** das Bauteil nach der Erwärmung unter Schutzgas auf eine Temperatur abgekühlt wird, bei keine Oxidation der Oberfläche des Bauteils stattfindet.

3. Verfahren nach Anspruch 2, **dadurch gekennzeichnet, daß** das Bauteil auf 80° C abgekühlt wird und anschließend mit einem Korrosionsschutzmittel behandelt wird.

4. Verfahren nach einem der vorhergehenden Ansprüche, **dadurch gekennzeichnet, daß** die Abkühlung in zwei Stufen erfolgt, wobei die Abkühlung in der zweiten Stufe mit Luft erfolgt.

5. Verfahren nach einem der vorhergehenden Ansprüche, **dadurch gekennzeichnet, daß** wenigstens zwei Fügestellen auf Prozeßtemperatur erwärmt und gleichzeitig durch Weichlöten miteinander verbunden werden.
